# EUROPEAN PATENT APPLICATION

(11) **EP 2 239 353 A1**
(43) Date of publication of application: **13.10.2010**
(21) Application number: 09157458.2
(22) Date of filing: 07.04.2009
(51) Int. Cl.: C23C 16/24

(54) **Photovoltaic cell deposition with minimized gas usage**

(71) Applicant: L'Air Liquide Société Anonyme pour l'Etude et l'Exploitation des Procédés Georges Claude, 75007 Paris (FR)
(72) Inventor: Chevrel, Henri, 78150 Le Chesnay (FR)
(74) Representative: Conan, Philippe Claude

(57) **Abstract**

A method for recovering and recycling silane and/or argon from a deposition chamber (6) used in a silicon layer deposition process using an argon dilution of silane, comprising at least the steps:
step a): collecting the silane and/or argon mixture exiting from the deposition chamber (6); and
step b): recycling the collected silane and/or argon to the deposition chamber (6).

## Description

The invention concerns a method for recovering and recycling silane and/or argon from a deposition chamber used in a silicon layer deposition process and a system for the implementation of such a method.

It is well known that the most common way of doing thin films photovoltaic cells is to deposit single junction made of amorphous silicon or tandem junction made of amorphous and microcrystalline using monosilane and hydrogen mixture (i.e active mixture) for the intrinsic layers and using monosilane and hydrogen mixture with doping gases such as phosphine (PH₃) or TMB (Trimethyl Boron) respectively for n or p doped layers. The deposition of the films are made using various techniques but the most well known is using Plasma Enhanced Chemical Vapor Deposition in large size reactors. The silicon element is brought by silicon hydrides (monosilane (SiH₄), disilane (Si₂H₆), trisilane (Si₃H₈)), silicon chlorides (SiCl₄), and silicon hydrochloride (SiHCl₃). Hydrogen is commonly used to enable the correct plasma regime able to provide enough energy and ion bombardment to increase the density of the films. Another reason is to provide hydrogen atoms to passivate and/or stabilize the dangling silicon bonds preventing thus decay in the performances of the deposited layers.

The recipes are usually ranging from 1% to 25% of SiH₄. The remaining gases being high purity hydrogen for intrinsic amorphous and micro or nanocrystalline silicon layers.

The utilization ratio of the silicon precursor is usually lower than 50% and often closer to 10% to 20% for amorphous silicon layer and closer to 30% up to 50% for the microcrystalline layers. This ratio is calculated by taking the amount of silicon molecules deposited on a substrate over the quantity of molecules brought to a reactor to perform the deposition or the amount of molecules present in the reactor exhaust over the quantity brought to the reactor for depositing the layers.

In most commonly used recipes the active mixture is essentially composed of hydrogen (over 90%). This gas, being the lightest, is very difficult to pump. So that, nitrogen is added upstream of a pump to enable molecular pumping, and in the pump to enable pump lubrication and dilution to get to hydrogen level lower or closer to the flammability threshold. Nitrogen dilution, as a consequence, brings the pump exhaust gas composition with level of nitrogen up to 70%.

The state of the art describes some recycling solutions, that either takes the gas from the reaction chamber, or after the pump. In the first case, as the principle is disclosed in WO 2008/154293 A1, the pumping to recover the gas mixture may affect the process conditions and the ability to discriminate hydrogen from silane is difficult. US5503657A describes a process using membrane separation of silane from hydrogen but none is describing in details any actual set up to implement such recovery before the pump as it can cause difficulties in pressure control of the deposition process.

The current silicon layer deposition process uses monosilane and hydrogen both in great quantities : a typical 60 MW peak / year production line uses between 25 tons and 50 tons of silane per year and from 250,000 Nm³ to 2,500,000 Nm³ of H₂ per year. The over all cost of gases represents in some cases 15% to 17% of the total cost of the PV modules. The silane and H₂ combined represents up to 8% to 10% of the total cost of the module.

Silane is provided to the manufacturing site as compressed gas in cylinder, bundles or iso-tube trailers containing up to 3 tons to 6 tons of silane. Hydrogen depending on the consumption is supplied either in compressed gas form by iso-container, in liquid form or produced on site using either electrolytic cells or SMR (Steam Methane reforming).

During the deposition, the silicon containing media is decomposed thanks to the energy provided by a plasma excitation created by a RF or Microwave plasma excitation and forms layers on the substrate (glass, metal sheets, polymer ...). The role of the silicon containing compound is to bring silicon atoms to the films. The role of the hydrogen is to enable a chemical environment necessary to obtain the good film microstructure and properties: amorphous with hydrogen content, or microcrystalline or nano-crystalline silicon. The suitable regimes depend on the pressure, the hydrogen dilution of silane (hence gas composition), the power and the type of electrostatic discharge (RF, MW...) applied to the plasma.

In the decomposition and deposition of silicon species, hydrogen leaves the chamber mostly non-reacted.

The processes in place today use hydrogen as diluting gases to deposit amorphous, and microcrystalline silicon layers from silane.

The drawback of such solution is that hydrogen needs dilution by heavy gas to be pumped, to maintain good deposition process parameters in the chamber. Additionally as hydrogen is a flammable gas, dilution by an inert gas is required for lower the hydrogen level downstream of the pumps and in the exhaust lines and finally to lubricate the pump. Today nitrogen (N₂) is used as the dilution gas because it is cheap and easily accessible.

The composition of the exhaust stream contains therefore small amount of silane and hydrogen in a larger portion of nitrogen. This stream composition renders the recycling and capture of silane and hydrogen unpractical and expensive, for process stability, safety and cost reasons.The present invention concerns a method for recovering and recycling silane and argon from a deposition chamber used in a silicon layer deposition process using an argon dilution of silane, comprising at least the steps:
step a): collecting the silane and argon exiting from the deposition chamber; and
step b): recycling the collected silane and argon to the deposition chamber.

According to another embodiment, the invention concerns a method as defined above, comprising before step a), the step:
identifying time periods during the deposition process when only excess silane, argon or silane/argon mixtures are exiting from the deposition chamber.

According to another embodiment, the invention concerns a method as defined above, wherein there is no hydrogen dilution of silane in said silicon layer deposition process.

According to another embodiment, the invention concerns a method as defined above, wherein the silicon deposition process is a thin film silicon layer deposition process.

According to another embodiment, the invention concerns a method as defined above, wherein the silicon deposition process is a solar cell manufacturing process.

According to another embodiment, the invention concerns a system without hydrogen source for deposition of a silicon layer comprising: a deposition chamber, a substrate held in the deposition chamber; a source of silane in communication with the deposition chamber; a source of argon in communication with the deposition chamber; an energy source associated with the deposition chamber for activating silane to deposit a silicon layer onto the substrate; a collection and recycling unit communicating with the deposition chamber for collecting excess silane and argon exiting the deposition chamber and for recycling collected silane and argon to the deposition chamber.

According to another embodiment, the invention concerns a system as defined above, comprising a pump at the exhaust of the deposition chamber and a switch box at the exhaust of the pump **characterized in that** said switch box is linked to the recycling unit.

According to another embodiment, the invention concerns a system as defined above, wherein the system is a system for depositing a silicon thin film.

According to another embodiment, the invention concerns a system as defined above, wherein the system is a system for manufacturing a solar cell.

According to another embodiment, the invention concerns a system as defined above, wherein the energy source is a thermal, radio frequency or microwave plasma energy source.

According to another embodiment, the invention concerns a system as defined above, wherein the substrate is contained in a shuttle deposition box in which the deposition occurs. Therefore no in situ cleaning steps are required. Cleaning of said shuttle deposition box is performed off line by either mechanical or chemical means. There is no need of cleaning gases; it is an advantage of the present invention.

According to another embodiment, the invention concerns the use of a system as defined above for the deposition of a silicon layer on a substrate in a deposition chamber.
Figure 1 is a typical gas supply schematic for silicon thin film PV cells plant.
Figure 2 is a schematic principle of low cost silicon thin film PV cell manufacturing using silane and argon recycling tool according to the present invention.

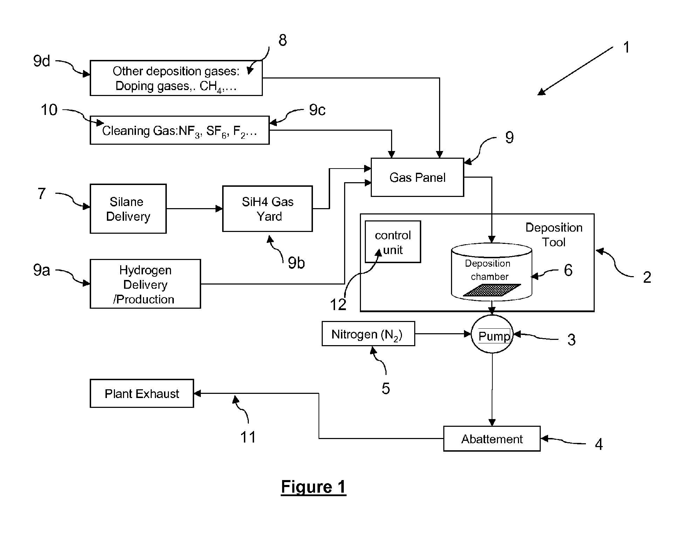

On figure 1, it is schematically represented a standard plant 1 for the manufacturing of silicon thin film PV cells.

The products once used in the reactor 2 are then pumped by a pump 3 to an abatement system 4 that burns the remaining silane and hydrogen. To abate completely this gases, large amount of energy are supplied to maintain at correct temperature the burn boxes of the abatement systems. Additionally nitrogen gas 5 is supplied in the pump 3 to enable sufficient pumping and lubrication of the pump moving parts and reduce the concentration to reach a safe level prior to the abatement of the flammable gases such as hydrogen, silane, polysilanes.... So in effect the deposition process is highly inefficient requiring for safety reason a dilution that increases the energy spending to abate the largely unused deposition process gases.

In the process of thin film silicon solar cell production, gases such as silane are flowed into a tool 2 comprising a deposition chamber 6, at pressures of about 0.1-1500 Pascal, and subjected to an energy source such as thermal, microwave or plasma, to cause a thin film of silicon to be deposited in the deposition chamber 6 as required for the performance of the solar cell electronic device being produced. For example, LP-PECVD (low pressures plasma enhanced chemical vapor deposition) processes can be used in solar cell manufacturing. In order to build up the layers of the solar cell, several gases and mixtures are generally used in a series of deposition steps. Silane 7 or silane/hydrogen mixtures are commonly used for depositing silicon layers, while silane mixed with other gases 8 such as Trimethyl Boron (TMB), Diborane (B₂H₆), Phosphine (PH₃), can be used to deposit layers of various composition.

The deposition chambers 6, receives process gas, e.g. silane, silane/hydrogen mixtures, or silane mixed with other deposition gases from the gas panel 9 in which silane, silane/hydrogen mixtures, or silane mixed with other deposition gases 8 are flown and mixed in respective specific quantity from their source boxes 9a, 9b, 9c, 9d. At times identified in the operation when only silane or silane/hydrogen mixtures are exiting the deposition chambers 6, the off gas is sent to an abatement unit 4. When other gases 8, e.g. boron, phosphorus, carbon, fluorinated gases etc. are present in the off gas from the deposition chambers 6, then the off gas is sent to the abatement unit 4, for disposal.

In some PECVD reactors type the deposition occurs directly in the reactor chamber. As the reactor is depositing thin films composed mostly of silicon some deposits are deteriorating the quality of the deposited new films (such as particles or inhomogeneities). Regular cleaning are applied using in situ or remotely generated plasma using cleaning gases 10 (mixtures of fluorinated gases such as NF₃, SF₆, and F₂ with or without Argon, O₂, or H₂). The cleaning reaction occurs when by products of the decomposition of fluorine containing gases into fluorinated radicals, with other gases. The radicals react with the deposits in the reactor to form volatile compounds. These cleaning reactions are performed at low pressure to enable sufficient radical life time, free mean path, and by products vaporization. The fluorinated radicals remove the silicon containing films from the interior of the reactor 2. The by products are composed mostly of SiF₄, and non reacted fluorine containing gases. These gases are treated in the abatement system 4 to prevent formation of HF in the exhaust line 11 that could create corrosion and leaks from the exhaust line into the environment. In the system of the figure 1, there is also a control unit 12.

In the present invention, the silicon layer deposition process uses the combination of both argon based mixtures for amorphous silicon (a-Si) and micro crystalline or nano crystalline (µc-Si, nc-Si) silicon layer (n doped, intrinsic and p doped). And the system for the implementation of said process of the present invention comprises a simplified recycling tool to purify the argon and silane mixture from H₂, N₂, impurities and doping gases. The over all solution brings the benefit of lower cost in silane, and diluting gas.

In the process of the present invention, there is no hydrogen dilution but an argon dilution and the necessary hydrogen for the silicon layer passivation is provided by the decomposition of silane (SiH₄ → a-Si-H + n H₂). The performances of this process are sufficient to be proposed as an alternative to hydrogen diluted process.

The main difficulty in recycling silane in the method according to the state of the art as described above is to get rid of the nitrogen used in pump dilution. Nitrogen has been found a poison for the silicon thin films PV efficiency as described by numerous papers in the state of the art. To get rid of nitrogen and other impurities in a mixture composed of up 70% with nitrogen uses a significant amount of energy, and requires a few purification / separation steps that increase the technical complexity and add several decomposition steps and therefore decrease the economical interest of such recycling.

The recycling process in the present invention can be composed of various separation purification steps such as selective membranes separation, adsorption desorption (PSA, TSA) steps cryo-condensation, cryogenic distillation, catalytic adsorption.

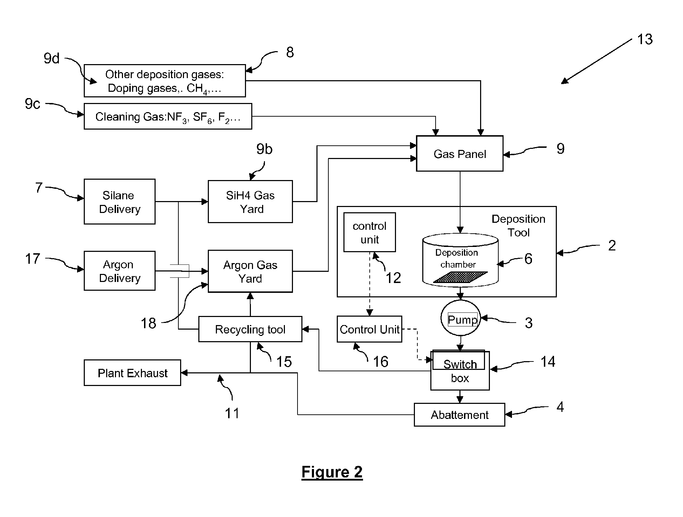

In figure 2, it is represented a schematic principle 13 of low cost silicon thin film PV cell manufacturing using silane and argon recycling tool according to the present invention. This system comprises the same elements 2 to 12 as in the system of figure 1, except the nitrogen source 5 linked to the pump 3 and the hydrogen delivery 9a, because there is no need of nitrogen in the process and the dilution of silane is made by argon and not hydrogen. The system 13 comprises also a source of argon 17. At the exhaust of this source, there is an Argon gas yard 18 in connexion with the source 17 and a recycling unit 15.

Moreover, the method of the invention implemented by the system represented in figure 2 comprises recycling steps taking into account specifically the argon dilution and the absence of nitrogen and hydrogen in a large part for the recycling of the silane and the recovery of argon.

A switch box 14 at the exhaust of the pump 3 prevents that during the process steps in which the gases either used or emitted which cannot be recycled such as fluorine containing cleaning gases from the source 9c, cleaning by product SiF₄ to be introduced into a recycling unit 15.

The aim of the control unit 12 is to drive the switching box 14 in order to flow gases containing gases to be recycled to the recycling unit or alternatively to the main exhaust treatment unit of the plant.

The recycling unit 15 is in connection with the argon gas yard and the SiH₄ gas yard 9b. As a matter of fact, when the switch box 14 makes the argon flow toward the recycling unit 15, the said recycling unit sends the argon in the argon gas yard 18 for the recycling and when the switch box 14 makes the silane flow toward the recycling unit 15, the said recycling unit sends the silane in the silane gas yard 9b for the recycling.

The switch box 14 can be composed of a valve automatically operated (pneumatic, electrically, for example by the control unit 16) and pipe work enabling diversion of exhaust flow to the abatement system 4 or to the recycling unit 15 depending on the process steps.

The switch box 14 is either controlled by the tool 2 or by a control box 16 that takes its information from the tool 2. This allows flowing recyclable gases to the recycling unit 15 and then to the process and the non-recyclable gases to the exhaust treatment unit 4 (abatement system).

In one embodiment the doping gases are not introduced to the recycling unit as they can contribute to make the purification of the silane or argon to level preventing performance deterioration too complex.

In another embodiment the cleaning gases 8 are not introduced to the recycling unit 15. Overall, the amount of gases non recyclable is very limited and this step is not detrimental to the overall economics as the process steps in which the doping gases are used is typically very short (a few seconds to a minutes compared to 15 to 45 minutes for the intrinsic silicon layer).

The present invention describes a system to minimize the usage of gases in manufacturing of silicon thin film cells.

This discovery applies for example to solar cell manufacturer that want to manufacture solar cell at lower cost (5%-8% lower than conventional process) by using both argon as a diluting gas and silane and argon recycling to minimize the gas consumption for their process.

The present invention enables the production of solar cell using the argon dilution as it reduces drastically the need for argon supply. The present solution allows the establishment of manufacturing site in area where hydrogen production is difficult (no natural gas availability) and with difficult silane logistics. The present invention allows the reduction of capital expenditure for solar cell manufacturing plants as safety will be intrinsically improved (no more flammable gas in large quantity). Particularly, it allows the reduction of risks associated with hydrogen.

## Claims

1. A method for recovering and recycling silane and argon from a deposition chamber (6) used in a silicon layer deposition process using an argon dilution of silane, comprising at least the steps:
step a): collecting the silane and argon mixture exiting from the deposition chamber (6); and
step b): recycling the collected silane and argon to the deposition chamber (6).

2. A method according to claim 1 comprising before step a), the step:
identifying time periods during the deposition process when only excess silane/argon mixtures are exiting from the deposition chamber.

3. A method according to anyone of claims 1 and 2, wherein there is no hydrogen dilution of silane in said silicon layer deposition process.

4. A method according to anyone of claims 1 to 3, wherein the silicon deposition process is a thin film silicon layer deposition process.

5. A method according to anyone of claims 1 to 4 wherein the silicon deposition process is a solar cell manufacturing process.

6. A system (13) without hydrogen source for deposition of a silicon layer comprising: a deposition chamber (6), a substrate held in the deposition chamber (6); a source of silane (7, 9b) in communication with the deposition chamber (6); a source of argon (17, 18) in communication with the deposition chamber (6) ; an energy source associated with the deposition chamber for activating silane to deposit a silicon layer onto the substrate; a collection and recycling unit (15) communicating with the deposition chamber (6) for collecting excess silane and argon exiting the deposition chamber (6) and for recycling collected silane and argon to the deposition chamber.

7. A system according to claim 6 comprising a pump (3) at the exhaust of the deposition chamber (6) and a switch box (14) at the exhaust of the pump (3) **characterized in that** said switch box (14) is linked to the recycling unit (15).

8. A system according to claim 6 or 7 **characterized in that** said switch box (14) is controlled by the deposition chamber (6).

9. The system of one of claims 6 to 8, wherein the system (13) is a system for depositing a silicon thin film.

10. The system of one of claims 6 to 8, wherein the system (13) is a system for manufacturing a solar cell.

11. The system of one of claims 6 to 10, wherein the energy source is a thermal, radio frequency or microwave plasma energy source.

12. Use of a system (13) as defined in one of claims 6 to 11 for the deposition of a silicon layer on a substrate in a deposition chamber (6).
